# DEMANDE DE BREVET EUROPEEN

(11) **EP 0 878 986 A1**
(43) Date de publication de la demande: **18.11.1998**
(21) Numéro de dépôt: 98500097.5
(22) Date de dépôt: 21.04.1998
(51) Int. Cl.: H05K 3/34, H01R 9/09, H01R 4/02

(54) **Un système et un pin d'interconnexion pour des circuits imprimés à double face par un double procédé, vague et refusion**

(30) Priorité: 16.05.1997 ES 9701051
(71) Demandeur: MECANISMOS AUXILIARES INDUSTRIALES S.A. M.A.I.S.A., E-43800 Valls, Tarragona (ES)
(72) Inventeur: Avila Martorell, Jose Ma, 43800 Valls, Tarragona (ES)
(74) Mandataire: Morgades Manonelles, Juan Antonio

(57) **Abrégé**

Résoudre les problèmes d'interconnexion électrique dans la fabrication de circuits imprimés, mais sans avoir à en subir les conséquences est l'un des objets de cette invention, un pin d'interconnexion qui nous garantisse une bonne connexion électrique et mécanique entre les deux faces d'un même circuit imprimé, compatible aux deux technologies de soudure énoncées: avec une de ses extrémités soudable par refusion et avec l'autre par vague. Le tack pin (17), voir figure nº 3, sera formé d'une tête large (18), qui se prolonge le long d'une tige (19), la configuration de ce tack pin (17) est la plus appropriée au nouveau type de soudure, consistant à employer la technique de la refusion sur la face supérieure et la technique de la vague sur la face inférieure.

## Description

La présente sollicitude de brevet d'invention consiste, conformément aux indications de l'énoncé, en un "UN SYSTEME ET UN PIN D'INTERCONNEXION POUR DES CIRCUITS IMPRIMES A DOUBLE FACE PAR UN DOUBLE PROCEDE, VAGUE ET REFUSION", dont les nouvelles caractéristiques permettent une meilleure interconnexion tant mécanique qu'électrique.

Plus concrètement, l'invention se réfère à l'une des opérations qui sont habituellement effectuées sur le montage de circuits imprimés, parmi lesquels se trouvent ceux à double face. Actuellement, pour l'union électrique des deux faces d'un circuit imprimé, on utilise un système d'interconnexion qui se base sur l'utilisation d'un pin transversal qui relie les deux faces du circuit imprimé qui est décrit dans le brevet du même titulaire nº 9200325 et est dénommé comme pin court ou au moyen d'un système habituellement utilisé sur le marché qui consiste dans la prévision d'une perforation de parois internes métallisées reliant les deux faces du circuit imprimé.

Le pin transversal précédemment décrit exige un procédé de soudure par vague pour être soudé aux deux faces du circuit imprimé et permettre ainsi le passage du courant entres elles, voir figure nº 1.

La dénommée perforation métallisée, voir figure nº 2, n'exige pas de soudure, contrairement au système qui utilise des pins plus courts; cependant, elle requiert un procédé de fabrication et des matériaux de circuit imprimé qui entraînent un surcoût qui fait que, dans de nombreux cas, il ne peut pas être absorbé par le marché en général, et les clients en particulier. En outre, l'application de perforations métallisées présentent des déficiences techniques dans l'environnement de notre application comme : pauvre capacité de courant à supporter, problèmes lors de son veillissement, instabilité dimensionnelle avec l'apparition de ruptures et de fissures sur leurs parois et autres effets non désirés.

Dans un autre ordre technique, l'introduction sur le marché de nouveaux composants électroniques tend à l'utilisation d'encapuchonnés en format SMD (composants de montage superficiel) que requiert un procédé de soudure par refusion, pour que le circuit imprimé puisse être soudé. Le montage de ces composants exige donc l'utilisation d'un procédé de soudure différent de celui utilisé par vague classique.

Étant donné la nécessité, pour ce type de produit, d'utiliser le type de composants décrits au paragraphe précédent, pour lequel il s'est déjà avéré qu'il demande absolument l'opération de soudure par refusion et d'autre part également la nécessité d'utiliser des composants soudables par vague; la perspective de base pour la disposition des deux types de composants sur un même circuit imprimé est de monter sur l'une des faces du circuit imprimé les composants par refusion et sur l'autre face les composants par vague. Toutefois, l'nterconnexion entre les deux faces du circuit imprimé n'est pas simple. Ainsi, le pin transversal d'interconnexion habituellement utilisée est inutile et d'autres part, pour les raisons susmentionnées, l'utilisation de solutions telles que la perforation métallisée n'est pas possible à cause de son coût excessif et parce qu'elles ne remplissent pas les conditions techniques exigées par le produit.

Pour résoudre les problèmes d'interconnexion électrique mais sans avoir à en subir les conséquences est l'un des objets de cette invention, un pin d'interconnexion qui nous garantisse une bonne connexion électrique et mécanique entre les deux faces d'un même circuit imprimé et compatible avec deux technologies de soudure énoncées : avec une de ses extrémités soudable par refusion et avec l'autre par vague.

D'autres détails et caractéristiques de l'actuelle sollicitude de brevet d'invention seront soulignés au cours de la description qui est donnée ci-dessous et qui fait référence aux figures accompagnant ce mémoire dans lequel sont représentés les détails préférés. Ces détails sont donnés à titre d'exemple et se réfèrent à un cas possible de réalisation pratique, mais ne demeurent pas limités aux détails et composants qui y sont exposés ; cette description doit donc être considérée d'un point de vue illustratif et sans aucune sorte de limitations.

On trouvera ci-dessous une liste numérotée des principaux éléments qui font partie de la présente invention; (10) circuit imprimé, (11) substrat diélectrique, (12) couches conductrices, (13) pistes, (14) soudure par vague, (15) perforation, (16) métallisée, (17) tack pin, (18) tête large, (19) tige.

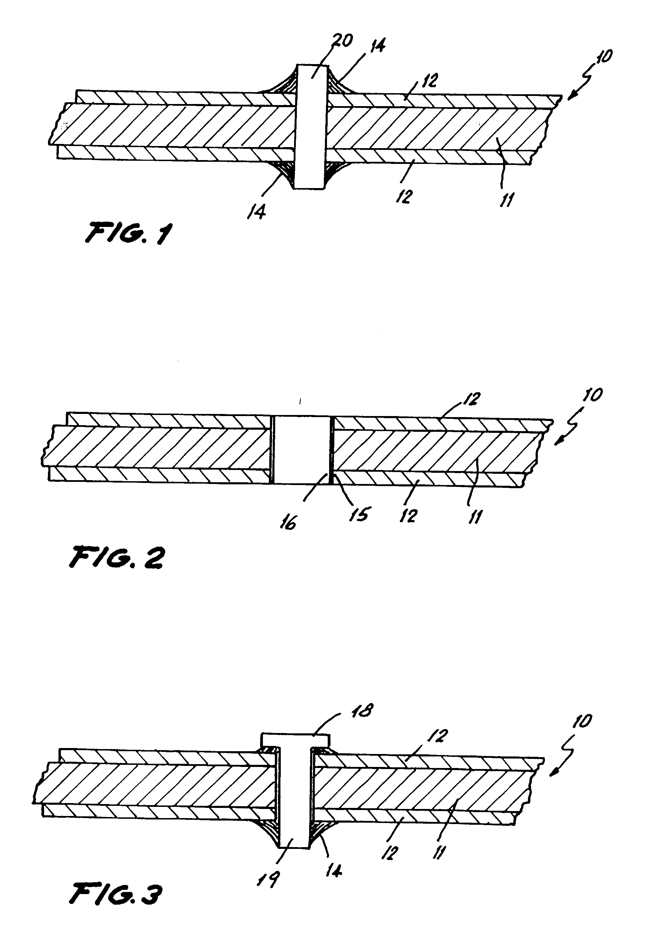

La figure nº 1 est une section longitudinale en élévation d'un circuit imprimé (10) conventionnel.

La figure nº 2 est une section longitudinale en élévation d'un circuit imprimé (10) sur lequel on a prévu, dans la zone centrale, une perforation métallisée (15-16).

La figure nº 3 est une section longitudinale en élévation d'un circuit imprimé (10) à double face sur lequel on a prévu un tack pin (17).

Sur l'une des réalisations de celles que l'on peut considérer comme un état de la technique, un circuit imprimé (10) à double face est formé par un substrat de nature diélectrique (11) qui, dans ce cas, est lui-même recouvert sur les deux faces de couches conductrices (12) munies d'un ensemble de pistes (13) non représentées sur les figures, voir figure nº 1.

De même que la solution connue pour mettre en contact les couches conductrices (12), on dispose d'un pin (20) qui traverse ces couches (12) et le substrat diélectrique (11), les extrémités de (20) à (12) étant soudées par le biais d'un procédé de soudure par vague, voir figure nº1.

Alternativement, et comme on peut le voir sur la figure nº 2, une autre solution également connue pour obtenir les mêmes résultats consiste à produire une perforation (15) affectant aussi bien les couches conductrices (12) que le substrat diélectrique (11), se recouvrant à l'intérieur par une métallisation (16), de sorte que certains points des couches sont mis en contact des deux côtés de (11).

Cependant, les solutions exposées à l'aide des figures nº 1 et 2 ne sont pas appropriées pour intégrer des composants électroniques sur les circuits imprimés à double face (10), ce qui fait que l'on a créé un nouveau système d'interconnexion consistant à insérer un nouveau type de pin dont la forme permet cette nouvelle technique.

Le tack pin (17), voir figure nº 3, est formé d'une tête large (18), qui se prolonge le long d'une tige (19), la configuration de ce tack pin (17) est la plus appropriée au nouveau type de soudure qui consistera à employer la technique de refusion sur la face supérieure et la technique de la vague sur la face inférieure. La configuration du tack pin (17) sera conforme au type d'appareil qui est utilisé pour le monter, ce qui fait qu'il n'est pas contraint à la configuration montrée sur la figure nº 3.

Le présent brevet d'invention ayant été suffisamment décrit en correspondance avec les plans ci-joints, il est entendu que toutes modifications de détail jugées opportunes pourront être introduites sur ceux-ci, à la condition de ne pas altérer l'essence de la patente qui se trouve résumée dans les REVENDICATIONS suivantes.

## Revendications

1. "UN SYSTEME ET UN PIN D'INTERCONNEXION POUR DES CIRCUITS IMPRIMES A DOUBLE FACE PAR UN DOUBLE PROCEDE, VAGUE ET REFUSION" de ceux qui sont formés d'un substrat diélectrique (11) recouvert sur les deux faces d'une couche conductrice (12) sur lesquels on a prévu des pistes (13), les deux faces (12) étant reliées électriquement à base de pins (20) ou à base de perforations métallisées (15-16), caractérisé par le fait que la soudure des composants électroniques des couches conductrices (12) et des pistes (13) sera effectuée par des techniques de refusion sur l'une des faces de (10), cependant que sur la face opposée on utilisera la technique de la vague, le tout à l'aide de tack pins (17).

2. "UN SYSTEME ET UN PIN D'INTERCONNEXION POUR DES CIRCUITS IMPRIMES A DOUBLE FACE PAR UN DOUBLE PROCEDE, VAGUE ET REFUSION" caractérisé selon la revendication précédente par le fait que les tack pins (17) présenteront une partie supérieure ou tête large (18) soudable par refusion et une tige (19) soudable par vague.
